# EUROPEAN PATENT SPECIFICATION

(11) **EP 2 852 082 B1**
(45) Date of publication and mention of the grant of the patent: **19.12.2018**
(21) Application number: 13809482.6
(22) Date of filing: 01.04.2013
(51) Int. Cl.: H04L 1/00

(54) **INFORMATION SENDING METHOD AND DEVICE**
INFORMATIONSSENDEVERFAHREN UND VORRICHTUNG
PROCÉDÉ ET DISPOSITIF POUR LA TRANSMISSION DE DONNÉES

(30) Priority: 29.06.2012 CN 201210222901
(43) Date of publication of application: 25.03.2015
(73) Proprietor: Huawei Technologies Co., Ltd., Longgang District Shenzhen, Guangdong 518129 (CN)
(72) Inventor: LUO, Yi, Shenzhen Guangdong 518129 (CN); DONG, Mingjie, Shenzhen Guangdong 518129 (CN); LI, Yunbo, Shenzhen Guangdong 518129 (CN)
(74) Representative: Epping - Hermann - Fischer
(86) International application number: PCT/CN2013/073576
(87) International publication number: WO 2014/000488

(56) References cited:
- WO-A1-01/03356
- CN-A- 1 372 735
- US-A1- 2009 006 921
- US-A1- 2009 196 244

## Description

### Field of the Technology

The present application relates to the field of data transmission, particularly to a method and a device for sending information.

### Background

Cyclic redundancy check (CRC) is a check algorithm based on principles of division and a remainder to control a correct rate of data transmission. Due to simplicity of encoding and a low error rate, CRC is widely used in communication systems.

A basic principle of cyclic redundancy check is that: a sender and a receiver adopt a same fixed generator polynomial G(X) having a highest power r.

At the sender, a polynomial of original information to be sent is represented as C(X). The C(X) being shifted to left by r bits is represented as rC(X). The rC(X) is divided by the generator polynomial G(X) to obtain an r-bit check code polynomial R(X). Then an encoded polynomial added with the cyclic redundancy check code T(X) = rC(X) + R(X) is obtained. And the T(X) is sent.

At the receiver, after the T(X) is received, the T(X) is divided by the fixed generator polynomial G(X). If an obtained remainder is 0, it indicates that the data transmission is correct.

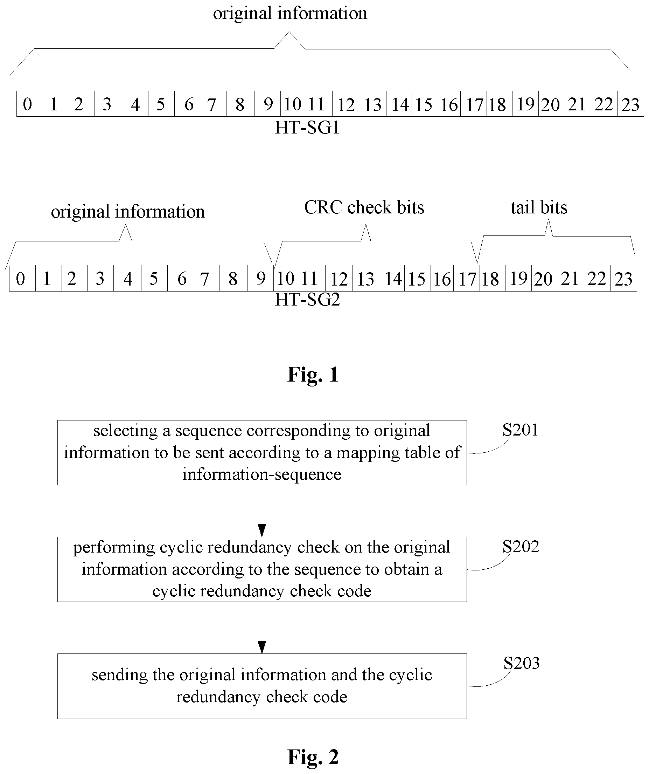

Original information can be transmitted with high efficiency by using cyclic redundancy check. For example, in an IEEE802.11 system of wireless local area networks (WLAN), a sender has a cyclic redundancy check code field in a high-throughput signal field (HT-SIG) or a very high-throughput signal field (VHT-SIG), to confirm that transmission of information contained in the (V)HT-SIG is correct. As shown in Fig. 1, the HT-SIG includes 48 bits, and includes two parts as HT-SIG 1 and HT-SIG2 having 24 bits, respectively. The 10th-18th bits of HT-SIG2 are cyclic redundancy check code bits, to protect original information of fields on 0-23rd bits of HT-SIG 1 and on 0-9th bits of HT-SIG2.

In practice, new data bits may be added to information transmitted. For example in the standard IEEE802.11ah, there are a large number of terminals. To save power, some terminals having no service become dormant. Therefore, new data bits are required to transfer a service type of a message. Because on 0-23rd bits of HT-SIG1 and on 0-9th bits of HT-SIG2 are already defined corresponding state information, substantive modifications of existing chips and protocols are required to add a new data bit, causing heavy development costs.

WO 01/03356 A1 discloses a flexible method of error protection in communications, without the need for explicit signaling from transmitter to receiver. At the transmitter side, a particular generator polynomial is used based on auxiliary information to perform CRC encoder on the information to be sent, and at the receiver side, decoder is performed with generator polynomials to find out the particular generator polynomial, which implicitly indicates the not-carried information. US 2009/196244 A1 discloses a method for encoding data unit by using plurality of CRC algorithms, and thus when decoding the data unit, a particular algorithm can be found out to implicitly indicate the not-carried information.

### Summary

A method for sending information and a device thereof are provided in this application, to transmit information efficiently without increasing data bits of original information, to reduce development costs.

An embodiment of the application is implemented as follows: a method for sending information, including:
selecting a sequence corresponding to information to be carried in original information to be sent according to a mapping table of information-sequence;
performing cyclic redundancy check on the original information by using the selected sequence as a generator polynomial to obtain a cyclic redundancy check code; and
sending the original information and the cyclic redundancy check code,
wherein the generator polynomial corresponding to the selected sequence has a highest power r, wherein r is greater than or equal to 1, and the performing cyclic redundancy check on the original information by using the selected sequence as a generator polynomial to obtain a cyclic redundancy check code includes:
   summing a sequence obtained by shifting the original information to left by r+1 bits and the selected sequence;
   shifting the sequence obtained by summing to left by r bits; and
   dividing the sequence obtained by shifting by the selected sequence, to obtain a remainder code which is the cyclic redundancy check code.

A device for sending information is provided in an embodiment of the application, and the device includes:
a selection unit, configured to select a sequence corresponding to information to be carried in original information to be sent according to a mapping table of information-sequence;
an encoding unit, configured to perform cyclic redundancy check on the original information by using the selected sequence as a generator polynomial to obtain a cyclic redundancy check code; and
a sending unit, configured to send the original information and the cyclic redundancy check code,
wherein the generator polynomial corresponding to the selected sequence has a highest power r, wherein r is greater than or equal to 1, and the encoding unit includes:
   a bit shifting and summing unit, configured to shifting original information to left by r+1 bits and then summing the obtained sequence and the selected sequences;
   a second bit shifting unit, configured to shift the sequence obtained by summing to left by r bits; and
   a second division unit, configured to perform an operation that the sequence obtained by shifting by the selected sequence, to obtain a remainder code which is the cyclic redundancy check code.

A method for receiving information is provided in an embodiment of the application, and the method includes steps as follows:
receiving a cyclic redundancy check code and original information;
dividing the original information and the cyclic redundancy check code with sequences in a mapping table of information-sequence in turn, until a sequence is obtained for which a remainder of the division is 0; and
obtaining information in the mapping table corresponding to the obtained sequence according to the mapping table of information-sequence,
wherein the dividing the original information and the cyclic redundancy check code with sequences in a mapping table of information-sequence in turn, until a sequence is obtained for which a remainder of the division is 0 includes:
   adding a sequence in the mapping table after the original information, and adding the cyclic redundancy check code after the sequence in the mapping table; and
   dividing the original information added with the sequence in the mapping table and the cyclic redundancy check code with sequences in the mapping table in turn.

A device for receiving information is provided in an embodiment of the application, and the device includes:
a receiving unit, configured to receive a cyclic redundancy check code and original information;
a decoding unit, configured to divide the original information and the cyclic redundancy check code with sequences in a mapping table of information-sequence in turn, until a sequence is obtained for which a remainder of the division is 0; and
an obtaining unit, configured to obtain information in the mapping table corresponding to the obtained sequence according to the mapping table of information-sequence,
wherein the decoding unit includes:
   a second addition unit, configured to add a sequence in a mapping table on the end of the original information, and to add the cyclic redundancy check code on the end of the sequence in the mapping table; and
   a fourth division unit, configured to perform an operation that the original information added with the sequence in the mapping table and the cyclic redundancy check code is divided by the sequences in the mapping table in turn.

In embodiments of the application, by selecting a sequence corresponding to information to be carried according to a mapping table of information-sequence stored in a sender and in a receiver, using the selected sequence as a generator polynomial to perform cyclic redundancy check encoding on the original information or on new information composed of the original information and the selected sequence to obtain a cyclic redundancy check code; sending the cyclic redundancy check code and the original information together to the receiver; performing, by the receiver, cyclic redundancy check decoding with a sequence in the stored mapping table after receiving the information; determining the sequence obtained in decoding is the sequence used in encoding by the sender in case that the result of decoding is correct; and searching for information corresponding to the sequence in the mapping table, the receiver is enabled to obtain the information. In the embodiments of the application, sending and receiving of information can be accomplished without increasing data bits of original information, and data can be transmitted efficiently. Compared with general technology in conventional art where data bits of original information is increased, no modifications on existing chips or protocols are required in the embodiments of the application, and development costs are saved.

### Brief Description of the Drawings

Fig. 1 is a diagram of format of data bits of HT-SIG;
Fig. 2 is a flow chart of implementation of a method for sending information provided in a first embodiment of the application;
Fig. 3 is a flow chart of implementation of a method for receiving information provided in the first embodiment of the application;
Fig. 4 is a flow chart of implementation of another method for sending information provided in a second embodiment of the application;
Fig. 5 is a flow chart of implementation of another method for receiving information provided in the second embodiment of the application;
Fig. 6 is a block diagram of a device for sending information and a device for receiving information provided in a third embodiment of the application; and
Fig. 7 is a block diagram of a device for sending information and a device for receiving information provided in a fourth embodiment of the application.

### Detailed Description of the Embodiments

In the embodiment, a conventional generator code adopted in cyclic redundancy check encoding and decoding is substituted with multiple sequences, and information corresponding to each sequence is agreed by both a sender and a receiver. When certain information is to be carried, the sender uses a sequence corresponding to the information as a generator polynomial to perform cyclic redundancy check encoding. At the receiver, a remainder 0 can be obtained if and only if a same sequence is used in decoding. The information corresponding to the sequence can be obtained according to a result of the decoding, and thus, and a process of carrying and transmission of information is accomplished. Various pieces of information are carried by different generator polynomials used in cyclic redundancy check encoding. And each piece of information can only be decoded with a generator polynomial same to the generator polynomial used in encoding of that piece of information. A sequence used in encoding is obtained by one-by-one decoding, and information corresponding to the sequence can be obtained by a table lookup. No modifications on chips or protocols are required, and development costs are low.

Fig. 2 shows a flow chart of implementation of a method for sending information provided in the application.

Step S201 includes: selecting a sequence corresponding to original information to be sent according to a mapping table of information-sequence.

In particular, a length of the sequence is determined according to the number of pieces of information at first. Theoretically, the number of pieces of information can be carried by a sequence having a length a is 2 to the power of a. But considering that a generator polynomial affects accuracy of a check result, if errors take place on different bits, remainders are different. After some sequences which affect the accuracy of the check result are exclude, the obtained sequences and the pieces of information are matched one by one, as shown in a table as follows:

| | |
|---|---|
| sequence 1 | information 1 |
| ............ | ............ |
| sequence K | information K |
| ............ | ............ |
| sequence N | information N |

In the embodiment, it is supposed that information K is to be carried, it can be known according to the table, the information K corresponds to a sequence K. So the sequence K is selected. It is supposed that a sequence is an 5-bit binary sequence 11001, then the polynomial corresponding to the sequence is x⁴+x³+1, having a highest power 4.

Step S202 includes: performing cyclic redundancy check on the original information according to the sequence to obtain a cyclic redundancy check code. There are multiple options for this step: cyclic redundancy check is performed on the original information with a generator polynomial corresponding to the selected sequence to obtain a cyclic redundancy check code; or cyclic redundancy check is performed directly on new information composed of the original information and the selected sequence to obtain a cyclic redundancy check code.

Is it supposed that a field code of original information to be sent is 1011001, a corresponding polynomial is x⁶+x⁴+x³+1. Shifting the polynomial to left by 4 bits, x¹⁰+x⁸+x⁷+x⁴ corresponding to a code 10110010000 is obtained. Dividing the sequence after the shifting with the sequence 11001 selected from the mapping table, an obtained remainder is the cyclic redundancy check code. Modulo 2 division is performed, i.e., an exclusive or operation is performed on a divisor and a dividend. The Highest bits of the divisor and the dividend are aligned when the exclusive or operation is performed.

Therefore, a cyclic redundancy check code corresponding to the embodiment is 1010.

Step 203 includes: sending the original information and the cyclic redundancy check code.

The cyclic redundancy check code 1010 obtained in the step S202 and the original information 1011001 are sent together to a receiver.

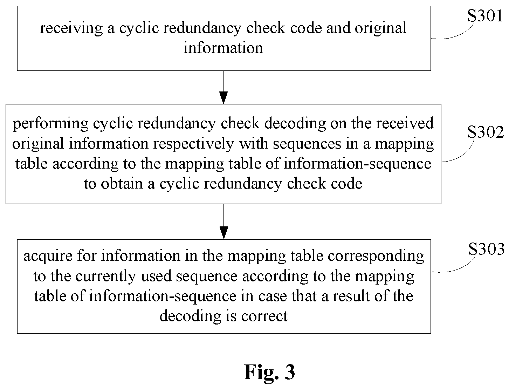

Fig. 3 shows a flow chart of implementation of a method for receiving information in the first embodiment of the application, which is described in detail as follows:
Step S301 includes: receiving a cyclic redundancy check code and original information.

The cyclic redundancy check code 1010 and the original information 1011001 sent in the step S203 are received.

Step S302 includes: performing cyclic redundancy check decoding on the received original information respectively with sequences in a mapping table according to the mapping table of information-sequence to obtain a cyclic redundancy check code.

Before cyclic redundancy check decoding is performed on received data, the receiver stores a mapping table of information sequence consistent to that at the sender. A process of the decoding includes:
adding the obtained cyclic redundancy check code 1010 directly on the end of the original information 1011001, to obtain a sequence 10110011010; dividing the sequence in turn with the sequences in the mapping table, i.e., during the process of decoding, dividing the sequence 10110011010 with a sequence 1 in the mapping table, sequence 2 in the mapping table, ..., till a sequence K is obtained when the remainder is 0. According to consistency of data in the mapping tables stored in the sender and in the receiver, the sequence K is 11001.

Step S303 includes: searching for information in the mapping table corresponding to the obtained sequence in case that a result of the decoding is correct.

The information K is obtained by searching the mapping table according to the sequence K 11001, i.e., the information K and the original information are successfully received by the receiver.

In the embodiment, transmission of data is accomplished accurately and effectively without adding data bits. The number of pieces of information carried is related to a length of a sequence. The number of mapping items in a mapping table can be adjusted according to the number of pieces of information. And a large amount of information can be carried.

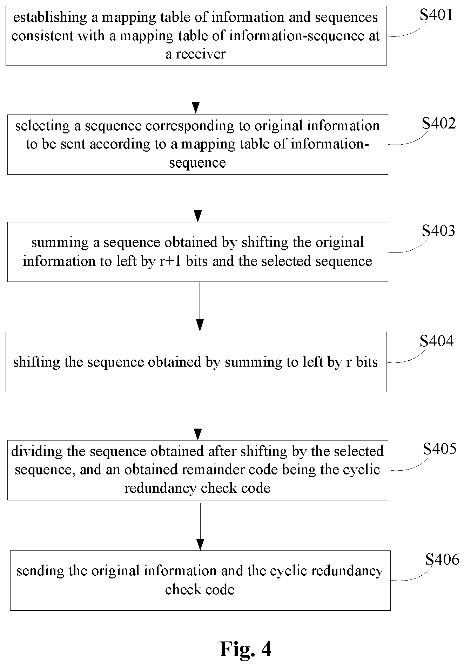

Fig. 4 shows a flow chart of implementation of another method for sending information provided in the embodiment of the application, which is described in detail as follows:
Step S401 includes: establishing a mapping table of information sequence consistent with a mapping table of information-sequence at a receiver.

Generally, the information is control information, or may be other information, which can be flexibly defined in the mapping table according to requirement of a user.

Here, before the cyclic redundancy check performed by the both sides of the data transmission, it is required to establish the mapping table of information-sequence which is consistent with the mapping table of information-sequence at the receiver. Statements in this step are consistent with the statements "establishing a mapping table of information-sequence consistent with a mapping table of information-sequence at a sender" in step S501. A user may keep consistency of the mapping tables at both the sender and the receiver by synchronous update or by importing data of the mapping table. In the embodiment, the established mapping table is as follows:

| | |
|---|---|
| control information bit sequence 1 | control information 1 |
| ............ | ............ |
| control information bit sequence K | the data packet is offloading type |
| ............ | ............ |
| control information bit sequence N | control information N |

Step S402 includes: selecting a sequence corresponding to original information to be sent according to the mapping table of information-sequence.

In the embodiment, it is supposed that control information to be sent is a data packet that is the offloading type, a control information sequence K corresponding to the control information is selected from the table. A highest power of a generator polynomial corresponding to the sequence K is r, where minimum of r is 1, i.e., a corresponding generator polynomial is x+1. It is supposed that the control information sequence K in the embodiment is 11001, the corresponding generator polynomial is x⁴+x³+1; the corresponding highest power of the polynomial is r=4; and the sequence corresponding to the original information to be sent is 1011001.

Step S403 includes: summing a sequence obtained by shifting the original information to left by r+1 bits and the selected sequence.

In particular, the original information 1011001 is shifted to left by r+1=5 bits, to obtain a sequence 101100100000. Summing the sequence 101100100000 and the selected sequence 11001, a sequence 101100111001 is obtained.

Step S404 includes: shifting the sequence obtained by summing to left by r bits.

The sequence 101100111001 obtained by summing in the step S403 is shifted to left by 4 bits, to obtain a sequence 1011001110010000.

Step S405 includes: dividing the sequence obtained after shifting by the selected sequence, to obtain an obtained remainder code which is the cyclic redundancy check code.

The sequence obtained by shifting is 1011001110010000. Dividing it by the selected control information bit sequence 11001, the obtained cyclic redundancy check code is 0001.

Step S406 includes: sending the original information and the cyclic redundancy check code.

Here, the original information 1011001 and the cyclic redundancy check code 0001 are sent together to the receiver.

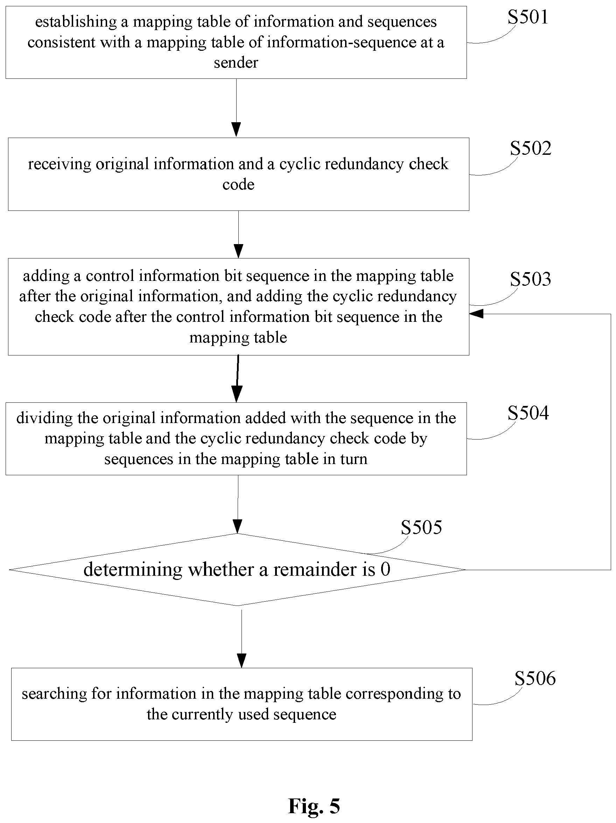

Fig. 5 shows a flow chart of implementation of a method for receiving information in the application.

Step S501 includes: establishing a mapping table of information-sequence consistent with a mapping table of information-sequence at a sender.

Here, a way of establishing the mapping table of information-sequences is same to that at the sender, and information is required to be synchronous and consistent with that at the sender, to ensure correction of carried information obtained by check.

Step S502 includes: receiving original information and a cyclic redundancy check code.

According to the step S406, the received information is the original information 1011001 and the cyclic redundancy check code 0001.

Step S503 includes: adding the control information bit sequence in the mapping table on the end of the original information, and adding the cyclic redundancy check code on the end of the control information bit sequence in the mapping table.

It is different from the first embodiment that, in this embodiment, the control information bit sequence in the mapping table is required to be added directly on the end of the original information, and then the cyclic redundancy check code is added on the end of the control information bit sequence in the mapping table. Alternatively, in other embodiments, the sequence in the mapping table may also be added in front of the original information. This embodiment is only for illustration of one of the manners. Operations in other manners are similar. The sequence 11001 in the mapping table corresponds to a polynomial having a highest power 4. Described in logical language, it includes: shifting the sequence of the original information to left by 4+1 bits, and summing the result of the shifting and the sequence in the mapping table, and then shifting the sequence obtained by summing to left by 4 bits, and summing the result of the shifting and the cyclic redundancy check code. If there are N sequences in a mapping table, then N sequences composed of original information, a control information bit sequence and a cyclic redundancy check code can be obtained, as shown in the following table:

| | |
|---|---|
| control information bit sequence 1 | original information-control information bit sequence 1-cyclic redundancy check code |
| ............ | ............ |
| control information bit sequence K | original information-control information bit sequence K-cyclic redundancy check code |
| ............ | ............ |
| control information bit sequence N | original information-control information bit sequence N-cyclic redundancy check code |

Step S504 includes: dividing the original information added with the sequence in the mapping table and the cyclic redundancy check code by sequences in the mapping table in turn.

The sequences on the right of the table are respectively divided by the corresponding sequences on the left.

Step S505 includes: determining whether a remainder is 0, turning to step S506 in case that the remainder is 0, turning to step S503 in case that the remainder is not 0.

Division operations are performed in turn from top to bottom of the table. It is determined whether the obtained remainders are 0. Remainders obtained are not 0 in the former K-1 operations. A remainder obtained is 0 in the K-th operation.

Step S506 includes: searching for information in the mapping table corresponding to the obtained sequence.

In the K-th operation, 1011001110010001 is divided by 11001. An obtained remainder is 0. The 11001 is the control information bit sequence K, and the corresponding control information is "the data packet is an offloading type", indicating that a type of the received data is offloading type.

Compared with the first embodiment, in this embodiment, the sequence selected in the mapping table is added on the end of the original information and then encoding is performed. In decoding, corresponding addition is required to obtain correct carried information. Here objects of encoding and decoding are different. Certainly, it should not be limited to the way illustrated in this embodiment that a selected sequence is added on the end of original information. Similarly, there are other combinations, where only objects of encoding and decoding are required to be modified. Even if another user obtains the mapping table of information-sequence, correct carried information can not be obtained by decoding if a sequence in the mapping table is not added on the end of original information or if decoding with combinations in other ways. Security of information transmission is improved to a certain degree.

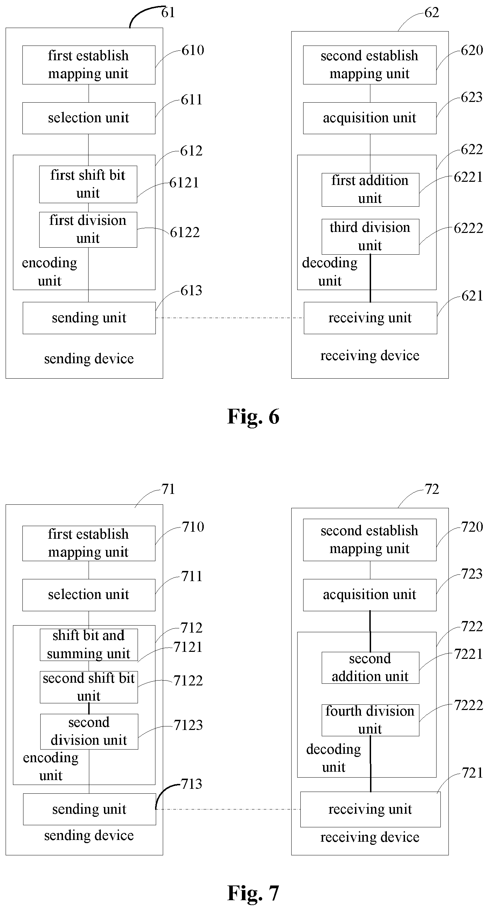

Fig. 6 shows a block diagram of a device for sending information and a device for receiving information in the application, where the sending device may be an access point AP or a station STA. It is described in detail as follows:
The sending device 61 includes a first mapping establishing unit 610, a selection unit 611, an encoding unit 612 and a sending unit 613. The receiving device 62 includes a second mapping establishing unit 620, a receiving unit 621, a decoding unit 622 and an obtaining unit 623. Where, the encoding unit 612 includes a first bit shifting unit 6121 and a first division unit 6122. The decoding unit 622 includes a first addition unit 6221 and a third division unit 6222. A selected sequence corresponds to a polynomial having a highest power r, where r is greater than or equal to 1.

The first mapping establishing unit 610 and the second mapping establishing unit 620 are configured to establish mapping tables of information-sequence having consistent contents at a sender and at a receiver. A process of the establishment may be that the mapping tables are directly stored in memories at both sides of communication by users, or the process of the establishment maybe that the mapping tables are synchronously adjusted via network by updating data contents of the tables.

The selection unit 611 is configured to select a sequence corresponding to original information to be sent according to the mapping table of information-sequence.

The encoding unit 612 is configured to perform cyclic redundancy check on the original information according to the sequence to obtain a cyclic redundancy check code, and the encoding unit 612 includes:
the first bit shifting unit 6121, configured to shift the sequence corresponding to the original information to left by r bits; and
the first division unit 6122, configured to perform an operation that the sequence obtained by shifting the sequence corresponding to the original information is divided by the selected sequence, to obtain a remainder code which is the cyclic redundancy check code.

The sending unit 613 is configured to send the original information and the cyclic redundancy check code.

The receiving unit 621 is configured to receive the original information added with the cyclic redundancy check code.

The decoding unit 622 is configured to, according to the mapping table of information-sequence, perform cyclic redundancy check decoding on the received original information added with the cyclic redundancy check code respectively with sequences in the mapping table.

The decoding unit 622 includes:
the first addition unit 6221, configured to add the cyclic redundancy check code directly on the end of the original information; and
the third division unit 6222, configured to perform an operation that the original information added with the cyclic redundancy check code is divided by the sequences in the mapping table.

The obtaining unit 623 is configured to search for information in the mapping table corresponding to the obtained sequence according to the mapping table in case that a result of the decoding is correct.

The block diagram of the devices provided in the embodiment corresponds to the method in the first embodiment. Details can be found in description of the first embodiment and are not repeated here.

Fig. 7 shows a block diagram of a device for sending information and a device for receiving information provided in another embodiment of the application.

Where the sending device 61 includes a first mapping establishing unit 710, a selection unit 711, an encoding unit 712 and a sending unit 713. The receiving device 72 includes a second mapping establishing unit 720, a receiving unit 721, a decoding unit 722 and an obtaining unit 723. Where, the encoding unit 712 includes a bit shifting and summing unit 7121, a second bit shifting unit 7122 and a second division unit 7123. The decoding unit 722 includes a second addition unit 7221 and a fourth division unit 7222.

Differences from the third embodiment lie in that the encoding unit 712 includes:
the bit shifting and summing unit 7121, configured to shifting original information to left by r+1 bits to obtain a sequence and then summing the obtained sequence and the selected sequences;
the second bit shifting unit 7122, configured to shift the sequence obtained by summing to left by r bits; and
the second division unit 7123, configured to perform an operation that the sequence obtained after shifting by the selected sequence, to obtain a remainder code which is the cyclic redundancy check code.

The decoding unit 722 includes:
the second addition unit 7221, configured to add a sequence in a mapping table on the end of the original information, and to add the cyclic redundancy check code on the end of the sequence in the mapping table; and
the fourth division unit 7222, configured to perform an operation that the original information added with the sequence in the mapping table and the cyclic redundancy check code is divided by the sequences in the mapping table in turn.

The block diagram of the devices provided in this embodiment corresponds to the method in the second embodiment. Details can be found in description of the second embodiment and are not repeated here.

It is noted that, the various units included in the embodiments of devices and systems are merely divided according to logical functions, but are not limited to the foregoing division, as long as the corresponding functions can be achieved. In addition, the name of each function unit is merely for distinguishing from each other, and is not to limit a scope of the application.

In addition, those skilled in the art can understand that implementation of all or a few steps in the methods in the foregoing embodiments may be accomplished by programs instructing relevant hardware. Corresponding programs may be stored in a computer readable storage medium, where the storage medium may be ROM/RAM, disk, or CD, etc.

The above described are merely preferable embodiments of the application, and are not to limit the application. The scope of the application should be consistent with the appended claims.

## Claims

1. A method for sending information, comprising:
selecting (S201) a sequence corresponding to information to be carried in original information to be sent according to a mapping table of information-sequence;
performing (S202) cyclic redundancy check on the original information by using the selected sequence as a generator polynomial to obtain a cyclic redundancy check code; and
sending (S203) the original information and the cyclic redundancy check code,
**characterized in that**, the generator polynomial corresponding to the selected sequence has a highest power r, wherein r is greater than or equal to 1, and the performing cyclic redundancy check on the original information by using the selected sequence as a generator polynomial to obtain a cyclic redundancy check code comprises:
summing (S403) a sequence obtained by shifting the original information to left by r+1 bits and the selected sequence;
shifting (S404) the sequence obtained by summing to left by r bits; and
dividing (S405) the sequence obtained by shifting by the selected sequence, to obtain a remainder code which is the cyclic redundancy check code.

2. The method for sending information according to claim 1, further comprising:
establishing the mapping table of information-sequence consistent with a mapping table of information-sequence at a receiver.

3. A device for sending information, comprising:
a selection unit (613, 711), configured to select a sequence corresponding to information to be carried in original information to be sent according to a mapping table of information-sequence;
an encoding unit (612,712), configured to perform cyclic redundancy check on the original information by using the selected sequence as a generator polynomial to obtain a cyclic redundancy check code; and
a sending unit (613, 713), configured to send the original information and the cyclic redundancy check code,
**characterized in that**, the generator polynomial corresponding to the selected sequence has a highest power r, wherein r is greater than or equal to 1, and the encoding unit (712) comprises:
a bit shifting and summing unit (7121), configured to shifting original information to left by r+1 bits and then summing the obtained sequence and the selected sequences;
a second bit shifting unit (7122), configured to shift the sequence obtained by summing to left by r bits; and
a second division unit (7123), configured to perform an operation that the sequence obtained by shifting is divided by the selected sequence, to obtain a remainder code which is the cyclic redundancy check code.

4. The device for sending information according to claim 3, further comprising:
a first mapping establishing unit (610, 710), configured to establish the mapping table of information-sequence consistent with a mapping table of information-sequence at a receiver.

5. A method for receiving information, comprising:
receiving (S301) a cyclic redundancy check code and original information;
dividing (S302) the original information and the cyclic redundancy check code with sequences in a mapping table of information-sequence in turn, until a sequence is obtained for which a remainder of the division is 0; and
obtaining (S303) information in the mapping table corresponding to the obtained sequence according to the mapping table of information-sequence,
**characterized in that**, the dividing the original information and the cyclic redundancy check code with sequences in a mapping table of information-sequence in turn, until a sequence is obtained for which a remainder of the division is 0 comprises:
adding (S503) a sequence in the mapping table after the original information, and adding the cyclic redundancy check code after the sequence in the mapping table; and
dividing (S504) the original information added with the sequence in the mapping table and the cyclic redundancy check code with sequences in the mapping table in turn.

6. The method for receiving information according to claim 5, further comprising:
establishing a mapping table of information and sequences consistent with a mapping table of information and sequences at a sender.

7. A device for receiving information, comprising:
a receiving unit (621, 721), configured to receive a cyclic redundancy check code and original information;
a decoding unit (622, 722), configured to divide the original information and the cyclic redundancy check code with sequences in a mapping table of information-sequence in turn, until a sequence is obtained for which a remainder of the division is 0; and
an obtaining unit (623, 723), configured to obtain information in the mapping table corresponding to the obtained sequence according to the mapping table of information-sequence,
**characterized in that**, the decoding unit (722) comprises:
a second addition unit (7221), configured to add a sequence in a mapping table on the end of the original information, and to add the cyclic redundancy check code on the end of the sequence in the mapping table; and
a fourth division unit (7222), configured to perform an operation that the original information added with the sequence in the mapping table and the cyclic redundancy check code is divided by the sequences in the mapping table in turn.

8. The device for receiving information according to claim 7, further comprising:
a second mapping establishing unit (620, 720), configured to establish the mapping table of information-sequence consistent with a mapping table of information-sequence at a sender.

## Patentansprüche

1. Verfahren zum Senden von Informationen, Folgendes umfassend:
Auswählen (S201) einer Sequenz, die Informationen entspricht, die in ursprünglichen Informationen übertragen werden sollen, die gemäß einer Abbildungstabelle von Informationen auf Sequenzen gesendet werden sollen;
Durchführen (S202) einer zyklischen Redundanzprüfung an den ursprünglichen Informationen unter Verwendung der ausgewählten Sequenz als ein Generatorpolynom, um einen zyklischen Redundanzprüfcode zu ermitteln; und
Senden (S203) der ursprünglichen Informationen und des zyklischen Redundanzprüfcodes,
**dadurch gekennzeichnet, dass** das Generatorpolynom, das der ausgewählten Sequenz entspricht, eine höchste Potenz r aufweist, wobei r größer oder gleich 1 ist, und das Durchführen einer zyklischen Redundanzprüfung an den ursprünglichen Informationen unter Verwendung der ausgewählten Sequenz als ein Generatorpolynom, um einen zyklischen Redundanzprüfcode zu ermitteln, Folgendes umfasst:
Summieren (S403) einer Sequenz, die durch Verschieben der ursprünglichen Informationen um r + 1 Bits nach links ermittelt wird, und der ausgewählten Sequenz;
Verschieben (S404) der Sequenz, die durch Summieren ermittelt wird, um r Bits nach links; und
Dividieren (S405) der Sequenz, die durch Verschieben ermittelt wird, durch die ausgewählte Sequenz, um einen Restcode zu ermitteln, welcher der zyklische Redundanzprüfcode ist.

2. Verfahren zum Senden von Informationen nach Anspruch 1, weiterhin Folgendes umfassend:
Herstellen der Abbildungstabelle von Informationen auf Sequenzen, die konsistent ist zu einer Abbildungstabelle von Informationen auf Sequenzen an einem Empfänger.

3. Vorrichtung zum Senden von Informationen, Folgendes umfassend:
eine Auswahleinheit (613, 711), die konfiguriert ist, eine Sequenz auszuwählen, die Informationen entspricht, die in ursprünglichen Informationen übertragen werden sollen, die gemäß einer Abbildungstabelle von Informationen auf Sequenzen gesendet werden sollen;
eine Codiereinheit (612, 712), die konfiguriert ist, eine zyklische Redundanzprüfung an den ursprünglichen Informationen unter Verwendung der ausgewählten Sequenz als ein Generatorpolynom durchzuführen, um einen zyklischen Redundanzprüfcode zu ermitteln; und
eine Sendeeinheit (613, 713), die konfiguriert ist, die ursprünglichen Informationen und den zyklischen Redundanzprüfcode zu senden,
**dadurch gekennzeichnet, dass** das Generatorpolynom, das der ausgewählten Sequenz entspricht, eine höchste Potenz r aufweist, wobei r größer oder gleich 1 ist und die Codiereinheit (712) Folgendes umfasst:
eine Bit-Schiebe- und Summiereinheit (7121), die konfiguriert ist, ursprüngliche Informationen um r + 1 Bits nach links zu verschieben und dann die ermittelte Sequenz und die ausgewählten Sequenzen zu summieren;
eine zweite Bit-Schiebeeinheit (7122), die konfiguriert ist, die Sequenz, die durch Summieren ermittelt wird, um r Bits nach links zu verschieben; und
eine zweite Dividiereinheit (7123), die konfiguriert ist, eine Operation durchzuführen, dass die Sequenz, die durch Verschieben ermittelt wird, durch die ausgewählte Sequenz dividiert wird, um einen Restcode zu ermitteln, welcher der zyklische Redundanzprüfcode ist.

4. Vorrichtung zum Senden von Informationen nach Anspruch 3, weiterhin Folgendes umfassend:
eine erste Abbildungsherstelleinheit (610, 710), die konfiguriert ist, die Abbildungstabelle von Informationen auf Sequenzen herzustellen, die konsistent ist zu einer Abbildungstabelle von Informationen auf Sequenzen an einem Empfänger.

5. Verfahren zum Empfangen von Informationen, Folgendes umfassend:
Empfangen (S301) eines zyklischen Redundanzprüfcodes und ursprünglicher Informationen;
Dividieren (S302) der ursprünglichen Informationen und des zyklischen Redundanzprüfcodes durch Sequenzen in einer Abbildungstabelle von Informationen auf Sequenzen eine nach der anderen, bis eine Sequenz ermittelt wird, für die ein Rest der Division 0 ist; und
Ermitteln (S303) von Informationen in der Abbildungstabelle, die der ermittelten Sequenz gemäß der Abbildungstabelle von Informationen auf Sequenzen entspricht, **dadurch gekennzeichnet, dass** das Dividieren der ursprünglichen Informationen und des zyklischen Redundanzprüfcodes durch Sequenzen in einer Abbildungstabelle von Informationen auf Sequenzen eine nach der anderen, bis eine Sequenz ermittelt wird, für die ein Rest der Division 0 ist, Folgendes umfasst:
Hinzufügen (S503) einer Sequenz in der Abbildungstabelle nach den ursprünglichen Informationen und Hinzufügen des zyklischen Redundanzprüfcodes nach der Sequenz in der Abbildungstabelle; und
Dividieren (S504) der ursprünglichen Informationen, zu denen die Sequenz in der Abbildungstabelle und der zyklische Redundanzprüfcode hinzugefügt wurden, durch Sequenzen in der Abbildungstabelle eine nach der anderen.

6. Verfahren zum Empfangen von Informationen nach Anspruch 5, weiterhin Folgendes umfassend:
Herstellen einer Abbildungstabelle der Informationen und Sequenzen, die konsistent ist zu einer Abbildungstabelle der Informationen und Sequenzen an einem Sender.

7. Vorrichtung zum Empfangen von Informationen, Folgendes umfassend:
eine Empfangseinheit (621, 721), die konfiguriert ist, einen zyklischen Redundanzprüfcode und ursprüngliche Informationen zu empfangen;
eine Decodiereinheit (622, 722), die konfiguriert ist, die ursprünglichen Informationen und den zyklischen Redundanzprüfcode durch Sequenzen in einer Abbildungstabelle von Informationen auf Sequenzen eine nach der anderen zu dividieren, bis eine Sequenz ermittelt wird, für die ein Rest der Division 0 ist; und
eine Ermittlungseinheit (623, 723), die konfiguriert ist, Informationen in der Abbildungstabelle zu ermitteln, die der ermittelten Sequenz gemäß der Abbildungstabelle von Informationen auf Sequenzen entspricht,
**dadurch gekennzeichnet, dass** die Decodiereinheit (722) Folgendes umfasst:
eine zweite Hinzufügeeinheit (7221), die konfiguriert ist, eine Sequenz in einer Abbildungstabelle am Ende der ursprünglichen Informationen hinzuzufügen und den zyklischen Redundanzprüfcode am Ende der Sequenz in der Abbildungstabelle hinzuzufügen; und
eine vierte Dividiereinheit (7222), die konfiguriert ist, eine Operation durchzuführen, dass die ursprünglichen Informationen, zu denen die Sequenz in der Abbildungstabelle und der zyklische Redundanzprüfcode hinzugefügt wurden, durch die Sequenzen in der Abbildungstabelle eine nach der anderen dividiert werden.

8. Vorrichtung zum Empfangen von Informationen nach Anspruch 7, weiterhin Folgendes umfassend:
eine zweite Abbildungsherstelleinheit (620, 720), die konfiguriert ist, die Abbildungstabelle von Informationen auf Sequenzen herzustellen, die konsistent ist zu einer Abbildungstabelle von Informationen auf Sequenzen an einem Sender.

## Revendications

1. Procédé d'envoi d'informations, comprenant de :
sélectionner (S201) une séquence correspondant à des informations à transporter dans des informations d'origine à envoyer conformément à une table de mappage d'informations-séquence ;
effectuer (S202) un contrôle de redondance cyclique sur les informations d'origine en utilisant la séquence sélectionnée en tant que un polynôme générateur pour obtenir un code de contrôle de redondance cyclique ; et
envoyer (S203) les informations d'origine et le code de contrôle de redondance cyclique,
**caractérisé en ce que** le polynôme générateur correspondant à la séquence sélectionnée a une puissance r plus élevée, où r est supérieur ou égal à 1, et l'exécution du contrôle de redondance cyclique sur les informations d'origine en utilisant la séquence sélectionnée en tant que polynôme générateur pour obtenir un code de contrôle de redondance cyclique comprend de :
sommer (S403) une séquence obtenue en décalant les informations d'origine vers la gauche de r + 1 bits et la séquence sélectionnée ;
décaler (S404) la séquence obtenue par la sommation vers la gauche de r bits ; et
diviser (S405) la séquence obtenue par le décalage par la séquence sélectionnée, pour obtenir un code de reste qui est le code de contrôle de redondance cyclique.

2. Procédé d'envoi d'informations selon la revendication 1, comprenant en outre de : établir la table de mappage d'informations-séquence en accord avec une table de mappage d'informations-séquence au niveau d'un récepteur.

3. Dispositif d'envoi d'informations, comprenant :
une unité de sélection (613, 711), configurée pour sélectionner une séquence correspondant à des informations à transporter dans des informations d'origine à envoyer conformément à une table de mappage d'informations-séquence ;
une unité de codage (612, 712), configurée pour effectuer un contrôle de redondance cyclique sur les informations d'origine en utilisant la séquence sélectionnée en tant que polynôme générateur pour obtenir un code de contrôle de redondance cyclique ; et
une unité d'envoi (613, 713), configurée pour envoyer les informations d'origine et le code de contrôle de redondance cyclique,
**caractérisé en ce que** le polynôme générateur correspondant à la séquence sélectionnée a une puissance r plus élevée, où r est supérieur ou égal à 1, et l'unité de codage (712) comprend :
une unité de décalage de bits et de sommation (7121), configurée pour décaler les informations d'origine vers la gauche de r + 1 bits et sommer ensuite la séquence obtenue et les séquences sélectionnées ;
une seconde unité de décalage de bits (7122), configurée pour décaler la séquence obtenue par la sommation vers la gauche de r bits ; et
une seconde unité de division (7123), configurée pour effectuer une opération selon laquelle la séquence obtenue par le décalage est divisée par la séquence sélectionnée, pour obtenir un code de reste qui est le code de contrôle de redondance cyclique.

4. Dispositif d'envoi d'informations selon la revendication 3, comprenant en outre :
une première unité d'établissement de mappage (610, 710), configurée pour établir la table de mappage d'informations-séquence en accord avec une table de mappage d'informations-séquence au niveau d'un récepteur.

5. Procédé de réception d'informations, comprenant de :
recevoir (S301) un code de contrôle de redondance cyclique et des informations d'origine ;
diviser (S302) les informations d'origine et le code de contrôle de redondance cyclique avec des séquences dans une table de mappage d'informations-séquence, jusqu'à obtenir une séquence pour laquelle un reste de la division est 0 ; et
obtenir (S303) des informations dans la table de mappage correspondant à la séquence obtenue selon la table de mappage d'informations-séquence,
**caractérisé en ce que**, la division des informations d'origine et du code de contrôle de redondance cyclique avec des séquences dans une table de mappage d'informations-séquence jusqu'à obtention d'une séquence pour laquelle un reste de la division est 0 comprend de :
ajouter (S503) une séquence dans la table de mappage après les informations d'origine, et ajouter le code de contrôle de redondance cyclique après la séquence dans la table de mappage ; et
diviser (S504) les informations d'origine auxquelles on a ajouté la séquence dans la table de mappage et le code de contrôle de redondance cyclique avec des séquences dans la table de mappage à tour de rôle.

6. Procédé de réception d'informations selon la revendication 5, comprenant en outre de : établir une table de mappage d'informations et de séquences en accord avec une table de mappage d'informations et de séquences au niveau d'un expéditeur.

7. Dispositif de réception d'informations, comprenant :
une unité de réception (621, 721) configurée pour recevoir un code de contrôle de redondance cyclique et des informations d'origine ;
une unité de décodage (622, 722) configurée pour diviser les informations d'origine et le code de contrôle de redondance cyclique avec des séquences dans une table de mappage d'informations-séquence, jusqu'à obtenir une séquence pour laquelle un reste de la division est 0 ; et
une unité d'obtention (623, 723), configurée pour obtenir des informations dans la table de mappage correspondant à la séquence obtenue selon la table de mappage d'informations-séquence,
**caractérisé en ce que** l'unité de décodage (722) comprend :
une seconde unité d'addition (7221), configurée pour ajouter une séquence dans une table de mappage à la fin des informations d'origine, et pour ajouter le code de contrôle de redondance cyclique à la fin de la séquence dans la table de mappage ; et
une quatrième unité de division (7222), configurée pour effectuer une opération selon laquelle les informations d'origine auxquelles on a ajouté la séquence dans la table de mappage et le code de contrôle de redondance cyclique sont divisés par les séquences dans la table de mappage à tour de rôle.

8. Dispositif de réception d'informations selon la revendication 7, comprenant en outre : une seconde unité d'établissement de mappage (620, 720), configurée pour établir la table de mappage d'informations-séquence en accord avec une table de mappage d'informations-séquence au niveau d'un expéditeur.
